# EUROPÄISCHE PATENTSCHRIFT

(11) **EP 0 302 351 B1**
(45) Veröffentlichungstag und Bekanntmachung des Hinweises auf die Patenterteilung: **06.10.1993**
(21) Anmeldenummer: 88111974.7
(22) Anmeldetag: 25.07.1988
(51) Int. Cl.: H05K 7/14

(54) **Elektronisches Gerät**
Electronical apparatus
Appareil électronique

(30) Priorität: 03.08.1987 DE 8710629 U
(43) Veröffentlichungstag der Anmeldung: 08.02.1989
(73) Patentinhaber: SIEMENS AKTIENGESELLSCHAFT, 80333 München (DE)
(72) Erfinder: Block, Siegfried, Dipl.-Ing., D-6744 Kandel (DE); Grosser, Benno, Dipl.-Ing., D-8451 Kümmersbruck (DE); Ninnemann, Peter, Dipl.-Ing., D-8551 Röttenbach (DE); Pavlik, Rolf-Dieter, Dipl.-Ing., D-8520 Erlangen (DE)

(56) Entgegenhaltungen:
- EP-A- 0 117 954
- DE-U- 8 623 013
- FR-A- 2 430 164
- US-A- 4 546 414

## Beschreibung

Die Erfindung betrifft ein elektronisches Gerät gemäß dem Oberbegriff des Anspruchs 1.

In Systemen der Prozeß- und Datentechnik sind im allgemeinen elektronische Geräte eingesetzt, die Baugruppenträger enthalten, in welche elektronische Baugruppen gesteckt sind. Wie z. B. in der Siemens-Zeitschrift 48 (1974), Heft 9, Seiten 668 bis 673 beschrieben, bestehen die Baugruppen aus einer rechteckigen Leiterplatte, die an ihrer hinteren Kante mit dem einen Teil von Steckverbindern versehen ist, deren zweiter Teil am Baugruppenträger angebracht ist. Diese zweiten Teile sind über eine Querverdrahtung miteinander verbunden, die im allgemeinen Leiterbahnen einer Leiterplatte sind. Bei eingeschobener Baugruppe ist die elektrische Verbindung zu dieser Querverdrahtung und damit zu anderen Baugruppen hergestellt. Die Baugruppen sind im allgemeinen Teilnehmer eines Bussystems.

Zur Leistungssteigerung werden häufig mehrere Bussysteme eingesetzt. Sogenannte lokale Busse verbinden mehrere Baugruppen zu einem Subsystem. Ein sogenannter Globalbus stellt die Verbindung zwischen den Lokalbussen und gegebenenfalls mit einer zentralen Einheit her. Ein Teil der Baugruppen ist nur an einen lokalen Bus, ein anderer Teil nur an den Globalbus angeschlossen. Wieder andere Baugruppen, z. B. Speicherbaugruppen, Zentraleinheiten, Ansteuerungen für periphere Elemente oder Übertragungseinheiten, welche die Verbindung von lokalen Bussen zum Globalbus herstellen, werden an einem Lokalbus und dem Globalbus gleichzeitig betrieben.

Aus dem DE-GM 86 23 013 ist das Problem bekannt, ein und dieselbe Baugruppe wahlweise an eines oder an das andere oder an beide Bussysteme eines elektronischen Gerätes anzuschließen. Zur Lösung dieses Problems ist ein Steckverbinder vorgeschlagen, dessen baugruppenträgerseitiger Teil symmetrisch zur in Steckrichtung verlaufenden Mittelachse ist, derart, daß die Baugruppen wahlweise in einer ersten Stellung oder in einer um 180° um die Steckrichtung gedrehten zweiten Stellung in die Steckplätze geschoben werden können. In der einen Stellung sind die Baugruppen mit dem einen und in der anderen Stellung mit dem anderen Bussystem verbunden. Dazu ist die Anzahl der Kontakte des baugruppenseitigen Teils des Steckverbinders etwa die Hälfte der Kontakte des baugruppenträgerseitigen Teils. Ist der baugruppenseitige Teil so groß, daß alle Kontakte des baugruppenträgerseitigen Teils kontaktiert werden, kann die Baugruppe mit beiden Bussystemen gleichzeitig verbunden werden. Der bekannte Steckverbinder hat den Nachteil, daß der baugruppenseitige Teil im Falle, daß die Baugruppe nur an ein Bussystem angeschlossen ist, doppelt so groß als erforderlich ist. Außerdem sind für die beiden Stellungen der Baugruppe je Baugruppe zwei Führungsschienen erforderlich.

Der vorliegenden Erfindung liegt die Aufgabe zugrunde, das elektronische Gerät mit den im Oberbegriff des Anspruchs 1 angegebenen Merkmalen so auszubilden, daß Baugruppen wahlweise an eines von mehreren Bussystemen angeschlossen werden können, ohne daß ein zusätzlicher Aufwand erforderlich ist.

Erfindungsgemäß wird diese Aufgabe mit den im kennzeichnenden Teil des Anspruchs 1 angegebenen Maßnahmen gelöst. Jede Baugruppe mit einem einzigen Steckverbinderteil kann daher in jeden Steckplatz mit einem baugruppenträgerseitigen Steckverbinderteil gesteckt werden und ist dort funktionsfähig. Entsprechend kann jede Baugruppe mit zwei Steckverbinderteilen in jedem Steckplatz mit zwei Steckverbindern betrieben werden. Da die beiden Steckverbinder baugruppenträgerseitig Verbindungen zu zwei verschiedenen Bussystemen herstellen, dienen solche Baugruppen im allgemeinen zur Kopplung von zwei Bussystemen bzw. zum Ankoppeln eines Lokalbusses an einen Globalbus. Steckplätze und Baugruppen mit mehr als zwei Steckverbindern sind zwar möglich, werden aber in der Regel nicht verwendet.

Wenn, wie üblich, eine Baugruppe an höchstens zwei Bussysteme gleichzeitig angeschlossen wird, gibt es hinsichtlich des baugruppenseitigen Teils der Steckverbinder nur zwei Baugruppentypen, nämlich solche, die nur an ein Bussystem und solche, die gleichzeitig an zwei angeschlossen werden. Baugruppen mit gleichen Funktionen können daher übereinstimmend aufgebaut werden, unabhängig davon, in welchem Bussystem sie betrieben werden sollen. Das Bussystem, an das eine Baugruppe angeschlossen wird, ist durch den Steckplatz bestimmt. Selbstverständlich müssen die Baugruppen hinsichtlich der Busschnittstelle elektrische Übereinstimmungen aufweisen, z. B. muß die Steckerbelegung identisch sein, und es müssen zumindest teilweise gleiche Signale für die verschiedenen Bussysteme verwendet werden.

Anhand der Zeichnungen, in denen schematisch ein Ausführungsbeispiel der Erfindung dargestellt ist, werden im folgenden die Erfindung sowie weitere Ausgestaltungen und Ergänzungen näher beschrieben und erläutert.

Es zeigen
- die Figuren 1a und 1b: die Anordnung der baugruppenträgerseitigen Teile von Steckverbindungen,
- Figur 2: eine Baugruppe zum Anschluß an zwei Bussysteme und
- Figur 3: eine Baugruppe zum wahlweisen Anschluß an eines von mehreren Bussystemen.

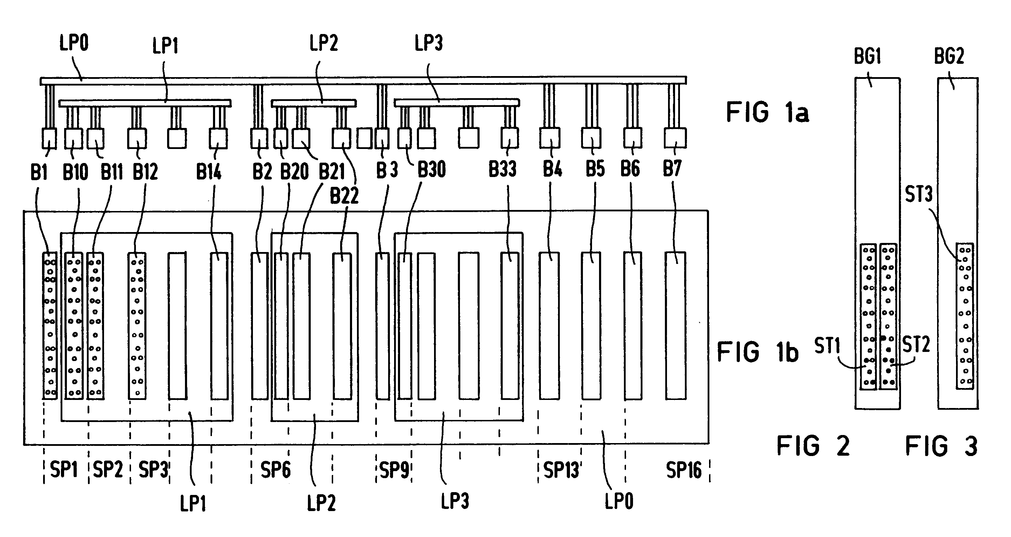

Figur 1 veranschaulicht die Anordnung der baugruppenträgerseitigen Teile von Steckverbindungen eines elektronischen Gerätes. Im Ausführungsbeispiel sind diese Teile Buchsenleisten B1, B10, B11, B12 ... Die Buchsenleisten B1, B2, B3, B4 ... B7 sind auf einer Leiterplatte LP0 befestigt, auf der parallel verlaufende Leiterbahnen sich befinden, welche einander entsprechende Kontakte der Buchsenleisten B1, B2 ... miteinander verbinden. Eine Leiterplatte LP1 trägt die Buchsenleiste B10, B11 ... B14 und verbindet deren Kontakte. Entsprechend sind die Buchsenleisten B20, B21, B22 und B30 ... B33 auf Leiterplatten LP2 und LP3 angebracht. Sämtliche Buchsenleisten sind nebeneinander angeordnet, die Leiterplatten liegen hintereinander. Anstelle getrennter Leiterplatten kann auch eine zweilagige Platte verwendet werden.

Der Baugruppenträger und damit das Gerät weist eine Vielzahl von Steckplätzen SP1, SP2, SP3 ... SP16 zur Aufnahme von Baugruppen unterschiedlicher oder gleicher elektrischer Funktion auf. Die Steckplätze SP1, SP6, SP9 enthalten je zwei Buchsenleisten, von denen die eine auf der Leiterplatte LP0 und die andere auf einer der Leiterplatten LP1, LP2, LP3 sitzt.

Figur 2 zeigt die Rückansicht einer für die Steckplätze SP1, SP6, SP9 vorgesehenen Baugruppe BG1. Sie weist zwei Steckerleisten ST1, ST2 auf, die, wenn die Baugruppe in einen der Steckplätze eingeschoben ist, in die Buchsenleisten B1, B10 bzw. B2, B20 bzw. B3, B30 gesteckt sind. Die anderen Steckplätze, z. B. SP2, SP3, SP16 enthalten jeweils nur eine Buchsenleiste, und zwar jeweils an derselben Stelle, im Ausführungsbeispiel in der linken Hälfte des für die Steckverbinder vorgesehenen Feldes. Selbstverständlich wäre auch eine andere Anordnung, z. B. in der rechten Hälfte oder in der Mitte, möglich. Die Rückseite einer für diese Steckplätze passenden Baugruppen BG2 ist in Figur 3 dargestellt. Sie weist lediglich eine einzige Steckerleiste ST3 auf. Die Baugruppe BG2 kann daher in jedem der Steckplätze SP2, SP3 ... mit einer Buchsenleiste gesteckt werden.

Die Baugruppen enthalten mit den Kontakten der Steckerleisten verbundene Busschnittstellen, die in Verbindung mit den Querverdrahtungen auf den Leiterplatten LP0, LP1, LP2, LP3 den Aufbau von Bussystemen gestatten. Das Ausführungsbeispiel enthält drei Subsysteme (Lokalbusse) mit den über die Leiterplatte LP1, LP2, LP3 verbundenen Baugruppen und ein übergeordnetes System (Globalbus) mit den Baugruppen in den Speicherplätzen SP1, SP6, SP9, SP13 ... SP16. Die Baugruppen mit zwei Steckerleisten in den Steckplätzen SP1, SP6, SP9 gehören jeweils zwei Systemen an. Sie stellen die Verbindung zwischen dem Globalbus und dem jeweiligen Lokalbus her. Auch die Baugruppen mit einer Steckerleiste haben z. T. die gleichen funktionellen Eigenschaften, z. B. Speicher, Analog- oder Digitaleingabe usw. Diese Baugruppen können wahlweise in einen Steckplatz für einen der Lokalbusse oder in einen Steckplatz des Globalbusses gesteckt werden, da ihr mechanischer Aufbau, insbesondere die Anordnung der Steckerleiste identisch ist. Selbstverständlich sind auch elektrische Übereinstimmungen erforderlich; z. B. müssen die Kontaktbelegungen von Global- und Lokalbus übereinstimmen. Auch muß der Lokalbus zumindest eine Untermenge der Signale des Globalbusses verwenden. Baugruppen mit übereinstimmenden Funktionen können daher identisch aufgebaut werden, unabhängig davon, an welchem Bussystem sie betrieben werden können.

## Patentansprüche

1. Elektronisches Gerät
- mit einem Baugruppenträger, der mehrere Steckplätze (SP1, SP2 ... SP16) enthält, in die Baugruppen (BG1, BG2) einschiebbar sind,
- mit ersten Teilen (Bi) von Steckverbindern, die an den Steckplätzen des Baugruppenträgers angebracht sind und in mindestens zwei Gruppen (B1, B2 ... B7; B10, B11, B12; B20, B21, B22; B30 ... B33) unterteilt sind, wobei an einem Steckplatz jeweils ein oder mehrere erste Teile angebracht sein können,
- mit einer Querverdrahtung (LP0, LP1, LP2, LP3) je Gruppe, die einander entsprechende Kontakte der ersten Teile (Bi) der Steckverbindungen einer Gruppe miteinander verbinden,
- mit zweiten Teilen (ST1, ST2, ST3) von Steckverbindern, die an einer senkrecht zur Steckrichtung verlaufenden Kante der Baugruppen (BG1, BG2) angebracht sind und die bei eingeschobenen Baugruppen mit den ersten Teilen der Steckverbinder verbunden sind und eine elektrische Verbindung zwischen Baugruppe und Baugruppenträger herstellen,
**gekennzeichnet durch:**
- die Steckplätze (SP1, SP2 ... SP16) des Baugruppenträgers weisen jeweils ein erstes Feld, ein zweites Feld und gegebenenfalls weitere Felder auf, in denen jeweils ein erstes Teil (Bi) eines Steckverbinders so angebracht werden kann, daß alle ersten Teile der Steckverbinder mit ihren Längsseiten parallel nebeneinander angeordnet sind;
- die in den ersten Feldern angebrachten ersten Teile (B1, B11, B12 ... B7) der Steckverbinder bilden mindestens eine Gruppe;
- die in den zweiten Feldern und die gegebenenfalls in weiteren Feldern angebrachten ersten Teile (B10, B20, B30) der Steckverbinder bilden jeweils mindestens eine Gruppe;
- die Baugruppen (BG1, BG2) weisen jeweils ein erstes Feld, ein zweites Feld und gegebenenfalls weitere Felder auf, in denen jeweils ein zweites Teil (ST1, ST2) eines Steckverbinders angebracht werden kann, derart, daß bei in einen Steckplatz eingeschobener Baugruppe ein im ersten Feld angebrachtes zweites Teil (ST2, ST3) mit dem ersten Teil (B1, B11, B12 ... B7) verbunden ist, das im ersten Feld des Steckplatzes angebracht ist, daß ein im zweiten Feld der Baugruppe angebrachtes zweites Teil (ST2) mit dem im zweiten Feld des Steckplatzes angebrachten ersten Teil (B10, B20, B30) des Steckverbinders verbunden ist und daß die in weiteren Feldern der Baugruppe angebrachten zweiten Teile mit den in den weiteren Feldern des Steckplatzes angebrachten ersten Teilen der Steckverbinder verbunden sind;
- in den Baugruppen (BG2) mit einem einzigen zweiten Teil (ST3) eines Steckverbinders ist der zweite Teil (ST3) stets im ersten Feld angebracht;
- in Baugruppen (BG1) mit zwei zweiten Teilen (ST1, ST2) sind diese stets im ersten und im zweiten Feld angebracht.

2. Elektronisches Gerät nach Anspruch 1, **dadurch gekennzeichnet,** daß die Querverdrahtungen in verschiedenen, bezüglich der Einschubrichtung der Baugruppen hintereinander angeordneten Ebenen liegen.

3. Elektronisches Gerät nach Anspruch 2, **dadurch gekennzeichnet,** daß die Querverdrahtungen Leiterbahnen von hintereinander angeordneten Leiterplatten (LP0, LP1, LP2, LP3) sind, auf denen jeweils die ersten Steckverbinderteile (B1, B2 ...; B10 ...; B20 ...) einer Gruppe angebracht sind.

4. Elektronisches Gerät nach Anspruch 2, **dadurch gekennzeichnet,** daß die Querverdrahtungen Leiterbahnen einer Multi-Layer-Platte sind.

## Claims

1. Electronic apparatus
- having a mounting rack which comprises several module positions (SP1, SP2 ... SP16), into which there can be inserted modules (BG1, BG2),
- having first parts (Bi) of connectors which are attached to the module positions of the mounting rack and are subdivided into at least two groups (B1, B2 ... B7; B10, B11, B12; B20, B21, B22; B30 ... B33), whereby one or several respective first parts can be attached to a module position,
- having a cross wiring (LP0, LP1, LP2, LP3) per group which connects together mutually corresponding contacts of the first parts (Bi) of the connectors of a group,
- having second parts (ST1, ST2, ST3) of connectors, which are attached to an edge of the modules (BG1, BG2), this edge extending perpendicularly to the direction of insertion, and which, when modules are inserted, are connected to the first parts of the connectors and form an electrical connection between the module and the mounting rack,
characterised in that:
- the module positions (SP1, SP2 ... SP16) of the mounting rack each have a first field, a second field and, if required, further fields, in which a respective first part (Bi) of a connector can be attached so that all of the first parts of the connectors are arranged with their longitudinal sides parallel next to each other;
- the first parts (B1, B11, B12 ... B7) of the connectors attached in the first fields form at least one group;
- the first parts (B10, B20, B30) of the connectors attached in the second fields and, if required, in further fields, form at least one group in each case;
- the modules (BG1, BG2) each have a first field, a second field and, if required, further fields, in which a respective second part (ST1, ST2) of a connector can be attached, so that, when a module is inserted into a module position, a second part (ST2, ST3) attached in the first field is connected to the first part (B1, B11, B12 ... B7), which is attached in the first field of the module position, in that a second part (ST2) attached in the second field of the module is connected to the first part (B10, B20, B30) of the connector attached in the second field of the module position, and in that the second parts attached in further fields of the module are connected to the first parts of the connectors attached in the further fields of the module position;
- in the modules (BG2) having a single second part (ST3) of a connector, the second part (ST3) is always attached in the first field;
- in modules (BG1) having two second parts (ST1, ST2), these second parts are always attached in the first field and the second field.

2. Electronic apparatus according to claim 1, characterised in that the cross wirings are located in different planes arranged successively relative to the direction of insertion of the modules.

3. Electronic apparatus according to claim 2, characterised in that the cross wirings are printed conductors of successively arranged printed boards (LP0, LP1, LP2, LP3) to which the respective first connector parts (B1, B2 ...; B10 ...; B20 ...) of a group are attached.

4. Electronic apparatus according to claim 2, characterised in that the cross wirings are printed conductors of a multi-layer board.

## Revendications

1. Appareil électronique comportant :
- un support de modules, qui comporte plusieurs emplacements d'enfichage (SP1, SP2 ... SP16) dans lesquels des modules (BG1, BG2) sont susceptibles d'être enfichés,
- des premières parties (Bi) de connecteurs à enfichage, qui sont montées aux emplacements d'enfichage du support de modules et qui sont subdivisées en au moins deux groupes (B1, B2 ... B7 ; B10, B11, B12 ; B20, B21, B22 ; B30 ... B33), une ou plusieurs des premières parties pouvant être montées en un emplacement d'enfichage,
- un câblage transversal (LP0, LP1, LP2, LP3) par groupe, qui relient entre eux des contacts correspondants des premières parties (Bi) de connections à enfichage d'un groupe,
- des deuxièmes parties (ST1, ST2, ST3) de connecteurs à enfichage, qui sont montées sur un bord, verticale dans la direction d'enfichage, des modules (BG1, BG2), et qui sont reliées, lorsque des modules sont enfichés, aux premières parties du connecteur à enfichage, en établissant une liaison électrique entre module et support de modules,
caractérisé par :
- les emplacements d'enfichage (SP1, SP2 ... SP16) du support de modules comportent chacun un premier champ, un deuxième champ et éventuellement d'autres champs, dans chacun desquels peut être montée une première partie (Bi) d'un connecteur à enfichage de telle façon que toutes les premières parties des connecteurs à enfichage sont disposées les unes à côté des autres, avec leurs bords longitudinaux parallèles ;
- les premières parties (B1, B11, B12 ... B7) des connecteurs à enfichage, qui sont montées dans les premiers champs, forment au moins un groupe ;
- les premières parties (B10, B20, B30) des connecteurs à enfichage, qui sont montées dans les deuxièmes champs et les premières parties des connecteurs à enfichage qui sont éventuellement montées dans d'autres champs, forment respecti-vement au moins un groupe ;
- les modules (BG1, BG2) comportent respectivement un premier champ, un deuxième champ et éventuellement d'autres champs supplémentaires, dans chacun desquels peut être montée une deuxième partie (ST1, ST2) d'un connecteur à enfichage de telle sorte que, dans le cas d'un module enfiché dans un emplacement d'enfichage, une deuxième partie (ST2, ST3) montée dans le premier champ, est reliée à la première partie (B1, B11, B12 ... B7) qui est montée dans le premier champ de l'emplacement d'enfichage, qu'une deuxième partie (ST2) montée dans le deuxième champ du module, est reliée à la première partie (B10, B20, B30) du connecteur à enfichage montée dans le deuxième champ de l'emplacement d'enfichage, et que les deuxièmes parties, montées dans lesdits autres champs du module, sont reliées aux premières parties des connecteurs à enfichage montées dans lesdits autres champs de l'emplacement d'enfichage ;
- dans les modules (BG2) comportant une seule deuxième partie (ST3) d'un connecteur à enfichage, la deuxième partie (ST3) est toujours montée dans le premier champ ;
- dans des modules (BG1) comportant deux deuxièmes parties (ST1, ST2), ces dernières sont toujours montées dans le premier et dans le deuxième champ.

2. Appareil électronique suivant la revendication 1, caractérisé en ce que les câblages transversaux sont disposés dans des plans différents, disposés les uns derrière les autres, dans le sens de la direction de l'enfichage des modules.

3. Appareil électronique suivant la revendication 2, caractérisé en ce que les câblages transversaux sont des pistes conductrices de plaquettes à circuits imprimés (LP0, LP1, LP2, LP3) disposées les unes derrière les autres, et sur chacune desquelles sont montées respectivement les premières parties de connecteur à enfichage (B1, B2 ... ; B10 ; B20 ...) d'un groupe.

4. Appareil électronique suivant la revendication 2, caractérisé en ce que les câblages transversaux sont des pistes conductrices d'une plaquette multicouche.
